(19) Europäisches Patentamt

European Patent Office

Office européen des brevets

(11) EP 1 564 566 A1

(12) EUROPEAN PATENT APPLICATION

(43) Date of publication:
17.08.2005 Bulletin 2005/33

(51) Int Cl.$^7$: G02B 5/28, G02B 3/00,
H01L 31/0232, H01L 31/0216

(21) Application number: 05003132.7

(22) Date of filing: 15.02.2005

(84) Designated Contracting States:
AT BE BG CH CY CZ DE DK EE ES FI FR GB GR
HU IE IS IT LI LT LU MC NL PL PT RO SE SI SK TR
Designated Extension States:
AL BA HR LV MK YU

(30) Priority: 17.02.2004 JP 2004040079

(71) Applicant: Seiko Epson Corporation
Shinjuku-ku, Tokyo 163-0811 (JP)

(72) Inventors:
• Mukaiyama, Hiroyuki
  Suwa-shi, Nagano-ken 392-8502 (JP)
• Komatsu, Akira
  Suwa-shi, Nagano-ken 392-8502 (JP)
• Hirayama, Masami
  Suwa-shi, Nagano-ken 392-8502 (JP)

(74) Representative: HOFFMANN - EITLE
Patent- und Rechtsanwälte
Arabellastrasse 4
81925 München (DE)

(54) **Dielectric multilayer filter and its manufacturing method, and solid-state imaging device**

(57)    The invention relates to providing a dielectric multilayer filter capable of minimizing the incident angle of light with respect to its dielectric multilayer film capable which reflects light of a given wavelength such as infrared light and making the angular dependence of the dielectric multilayer film as small as possible. A dielectric multilayer filter 1 including: a light-transmissive substrate 2 having a flat surface at least one side thereof; a dielectric multilayer film 3 formed on the flat surface of the light-transmissive substrate 2, the dielectric multilayer film reflecting light of a particular wavelength; and a resin focusing lens 4 glued on the at least one side of the light-transmissive substrate 2. The dielectric multilayer filter 1 is used as a dust-tight cover of the solid-state imaging element's device 100.

F I G. 3

EP 1 564 566 A1

**Description**

[Technical Field]

The present invention relates to a dielectric multilayer filter used as an infrared cutoff filter, etc. employed in a digital camera, etc. and its manufacturing method, and a solid-state imaging device with the filter.

[Background Art]

There have been used a lot of CCDs (Charge Coupled Devices) as solid-state imaging elements including a video camera and a digital camera. CCDs are sensitive to light having a relatively wide wavelength and have a good sensitivity with respect to light in not only a visible light region but also a near-infrared region (750-2,500nm). However, an infrared region, in which light is invisible for human beings, is not required in usual cameras' applications. Near infrared rays, which have entered a solid-state imaging element, may cause defects, such as degradation of resolution and unevenness in an image. On this account, an optical system of a video camera, etc. is arranged so as to cut off near infrared rays of an incident light by therein inserting an infrared cutoff filter such as a colored glass.

From the demands to downsize video cameras and digital cameras in recent years, it has been proposed to impart the function of an infrared cutoff filter to a lens included in an optical system in e.g., Patent Document 1. In addition, Patent Document 2 has proposed that the incident angle of a light beam entering a solid-state imaging element is reduced by shaping an infrared cutoff filter into a lens form.

Infrared cutoff filters include an absorption-type filter with its base material kneaded with an infrared absorbing substance and an interference-type filter which utilizes the interference caused by a dielectric multilayer film to reflect infrared rays. The interference-type filter can be formed on surfaces of various base materials because it is formed by growing a dielectric multilayer film, and therefore the interference-type filter is favorable for downsizing optical systems. Further, the interference-type filter is characterized in the transmittance of a required wavelength can be increased, and by its lower cost and higher degree of freedom in spectral characteristics.

Therefore, Patent Document 3 has proposed that an infrared cutoff filter composed of a dielectric multilayer film for reflecting infrared rays is united with a lens or a low-pass filter to eliminate the infrared rays' cutoff filter used as a part and promote the downsizing of its optical system.

Meanwhile, a solid-state imaging element is often employed as a solid-state imaging device in the condition where it is encapsulated in a package in order to prevent the attachment of dust. In the package of a solid-state imaging device is incorporated a dust-tight cover which allows light to pass therethrough to the solid-state imaging element and serves to seal the package.

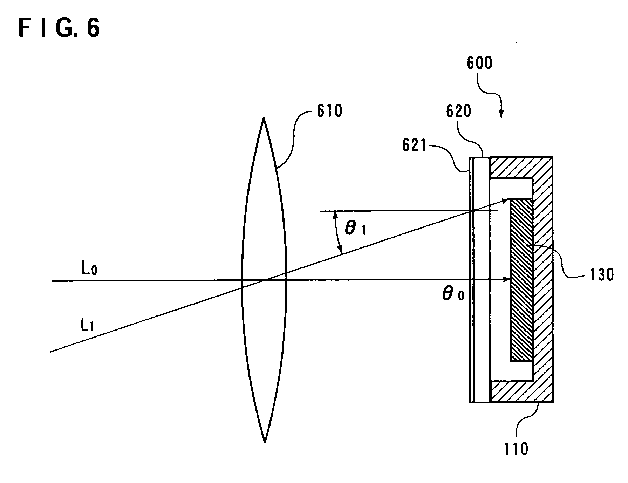

Therefore, it has been be devised that a dielectric multilayer film 621 for cutting off infrared rays is provided on a dust-tight cover 620 for encapsulating a solid-state imaging element 130 in a package 110 like the solid-state imaging element's device 600 schematically shown in Fig. 6, thereby to eliminate an infrared rays' cutoff filter as a part and promote the downsizing of its optical system.

[Patent Document 1] JP-A-2002-40234

[Patent Document 2] JP-A-2002-341241

[Patent Document 3] JP-A-H05-207350

[Disclosure of the Invention]

[Problems that the Invention is to Solve]

However, the dielectric multilayer film 621 has an angular dependence such that the characteristics thereof differ depending on the incident angle. As shown in Fig. 6, the light which has passed through the optical system 610 goes through the dust-tight glass 620 provided with the dielectric multilayer film 621 and then is condensed onto the solid-state imaging element 130. The light $L_0$ which takes the optical axis of the optical system 610 will impinge on the center of the solid-state imaging element 130 in the condition where its incident angle to the dielectric multilayer film 621 is zero, while the light $L_1$ which will impinge on an end portion of the solid-state imaging element 130 will be incident on the dielectric multilayer film 621 at an incident angle of $\theta_1$.

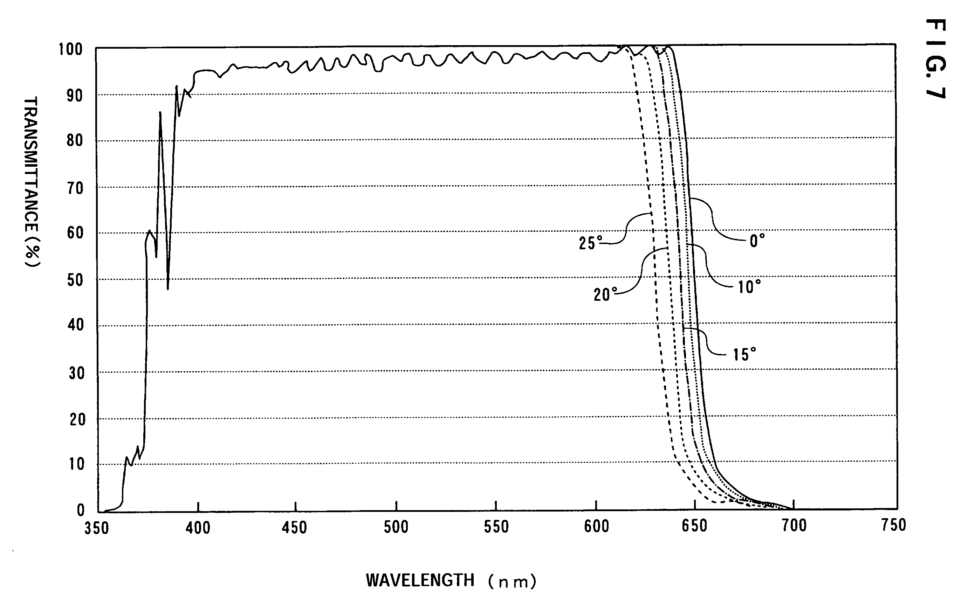

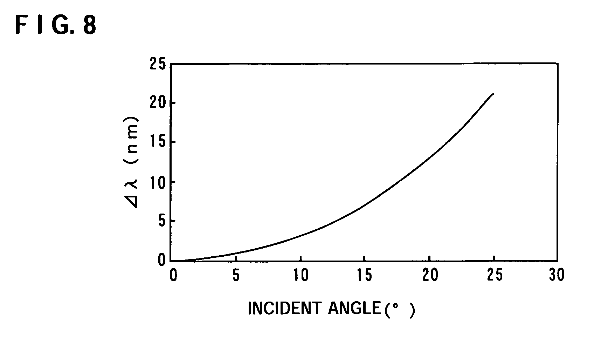

The spectral characteristics of the dielectric multilayer film for cutting off infrared rays are shown in Fig. 7. As the incident angle increases, a wavelength of a falling edge in proximity to a wave length of 650nm greatly shifts to a shorter wavelength side mainly. Fig. 8 is a graph showing changes in the wavelength of the falling edge corresponding to a transmittance of 50% with respect to incident angles, with reference to the wavelength of the falling edge corresponding to a transmittance of 50% when the incident angle is zero. As an incident angle increases, the wavelength of the falling edge is dislocated toward a shorter wavelength side, causing red-color rays to be cut off. The incident angle of light impinging on the solid-state imaging element 130 nearer to the end portion of the element becomes larger and as such, an image resulting from the conversion of an optical image into electric signals by the solid-state imaging element 130 develops a tendency to be deeper bluish farther from the central portion thereof nearer to peripheral portions, which causes unevenness of color in the picture plane.

The invention was made in consideration of the above reason. It is an object of the invention to provide a dielectric multilayer filter which can keep the incident angle of light with respect to a dielectric multilayer film for reflecting light of a given wavelength such as infrared rays as small as possible thereby to minimize the angular dependence of the dielectric multilayer film.

It is also an object of the invention to provide a dielectric multilayer filter's manufacturing method which enables production of such dielectric multilayer filter at low cost.

Further, it is an object of the invention to provide a solid-state imaging element's device in which such dielectric multilayer filter is used as a dust-tight cover.

[Means for Solving the Problems]

In order to achieve the above objects, the invention first provides a dielectric multilayer filter characterized by having:

a light-transmissive substrate having a flat surface on at least one side thereof;
a dielectric multilayer film for reflecting light of a particular wavelength formed on the flat surface of the light-transmissive substrate; and
a focusing lens made of a resin glued on the at least one side of the light-transmissive substrate.

Since the dielectric multilayer film is difficult to form on a curved surface, the face of the light-transmissive substrate to form the dielectric multilayer film thereon is required to be flat. The resin focusing lens glued on a surface of the light-transmissive substrate refracts a light beam incident on the dielectric multilayer film at an oblique angle so as to converge toward the optical axis and as such, the following are made possible: to minimize the incident angle of a light beam with respect to the dielectric multilayer film; and to make the angular dependence of the dielectric multilayer film as small as possible.

Second, the invention provides the first dielectric multilayer filter, characterized in that the light-transmissive substrate has at least one birefringent plate.

One or more birefringent plates can constitute an optical low-pass filter. Therefore, it becomes possible to arrange a dielectric multilayer filter which can also serve as an optical low-pass filter by making the light-transmissive substrate a low-pass filter.

Third, the invention provides the first dielectric multilayer filter, characterized in that the light-transmissive substrate is an optical low-pass filter having a first birefringent plate,
        a second birefringent plate and
        a polymer film serving as a quarter wave plate and sandwiched between the first birefringent plate and the second birefringent plate.

The optical low-pass filter is of a four-point separation and high performance type, and is thinner in comparison with a conventional optical low-pass filter including three birefringent plates. Therefore, the filter can be made thinner.

Fourth, the invention provides the first dielectric multilayer filter, characterized in that the light-transmissive substrate is an absorption-type filter for absorbing light of a particular wavelength.

By combining an absorption-type filter for absorbing light of a particular wavelength and a dielectric multilayer film for reflecting light of a particular wavelength, stray light, which is produced when the reflected light produced by reflection by the dielectric multilayer film is reflected by another member and which enters the filter again, is absorbed by the absorption-type filter can be absorbed by the absorption-type filter, whereby the stray light can be completely prevented from being incident on the solid-state imaging element.

Fifth, the invention provides any one of the first to fourth dielectric multilayer filters, characterized in that an outer surface of the resin focusing lens is aspheric.

By making the optical surface of the focusing lens aspheric, it becomes possible to arrange the focusing lens with its various kinds of aberrations corrected properly and therefore an image of good quality can be obtained.

Sixth, the invention provides any one of the first to fourth dielectric multilayer filters, characterized in that a half value, which is a wavelength indicating half of a maximum transmittance of the dielectric multilayer film, falls in a range of $650 \pm 30$nm.

By setting the half value in the range of $650 \pm 30$nm, it becomes possible to cut off near infrared rays deleterious to a solid-state imaging element. This allows the dielectric multilayer filter to serve as an infrared cutoff filter.

Seventh, the invention provides a method of manufacturing a dielectric multilayer filter, characterized by having:

a molding process including the steps of
preparing a hybrid lens molding means by combining a light-transmissive substrate in a plate form having a dielectric multilayer film for reflecting light of a particular wavelength provided on one side or two opposed sides thereof, and a convex face-forming-use molding die having a shaping face and a plurality of concave cavity portions each for transferring a focusing lens form onto a target surface provided in the shaping face, with the shaping face facing the light-transmissive substrate,
charging a curable composition-based material into the plurality of concave cavity portions of the hybrid lens molding means, and
curing the curable composition-based material;
a dicing process including the steps of
removing the convex face-forming-use molding die, and
dicing the light-transmissive substrate for each resin focusing lens formed on a surface of the light-transmissive substrate by curing the curable composition-based material.

With the molding process, many resin focusing lenses can be formed on a surface of the light-transmissive substrate in one molding work. Also, the dicing process, in which the focusing lenses are cut out from the light-transmissive substrate for each lens, allows many dielectric multilayer filters to be manufactured simply and easily. Therefore, the dielectric multilayer filter can be manufactured at low cost.

Eighth, the invention provides a solid-state imaging device characterized by having:

a package having an opening;
a solid-state imaging element secured inside the package so as to face the opening; and
a plate-shaped transparent dust-tight cover for obturating the opening,

wherein the dust-tight cover is a dielectric multilayer filter having: a light-transmissive substrate in a plate form;
a dielectric multilayer film for reflecting light of a particular wavelength, the dielectric multilayer film formed on at least one side of the light-transmissive substrate; and
a resin focusing lens glued to a face on an incident side of the light-transmissive substrate.

By adopting the dielectric multilayer filter of the invention as the dust-tight cover of the solid-state imaging device, it becomes possible to impart the function of an infrared cutoff filter with its angular dependence minimized to the dust-tight cover.

[Brief Description of the Drawings]

[Figs. 1(a)-(c)] They are cross sectional views showing various forms of the dielectric multilayer filter of the invention.

[Fig. 2] It is a cross sectional view showing the structure of an embodiment of the solid-state imaging element's device of the invention.

[Fig. 3] It is an optical path illustration of assistance in explaining the function of reducing an incident angle in association with the dielectric multilayer filter of the invention.

[Figs. 4(a)-(d)] They are flow charts of assistance in explaining the process steps of the dielectric multilayer filter's manufacturing method of the invention.

[Figs. 5(a), (b)] They are cross sectional views of a lens of an example for comparison (a) and a lens in association with the invention (b), respectively.

[Fig. 6] It is an optical path illustration of assistance in explaining the incident angle in a conventional dust-tight cover.

[Fig. 7] It is a graph showing an example of the spectral transmittance of the dielectric multilayer film.

[Fig. 8] It is a graph showing the angular dependence of the dielectric multilayer film.

[Best Mode of Carrying Out the Invention]

While the embodiments of the dielectric multilayer filter, manufacturing method, and solid-state imaging device of the invention will be described below, the invention is not limited to the embodiments below.

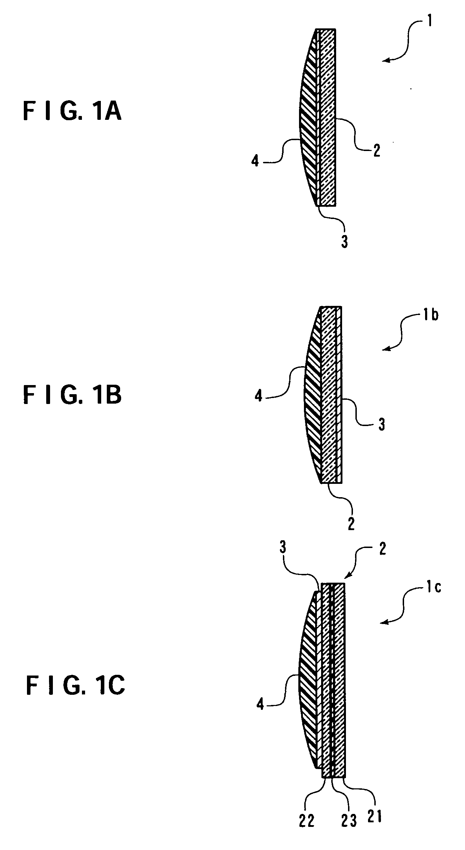

Fig. 1 shows a structure of an embodiment of the dielectric multilayer filter of the invention in cross section. The dielectric multilayer filter 1 shown in Fig. 1(a) has the structure of a hybrid lens having: a light-transmissive substrate 2 in the form of a plate with two opposed flat surfaces; a dielectric multilayer film 3 formed on one side of the light-transmissive substrate 2; and a plane-convex lens made of a resin with its flat surface glued on the dielectric multilayer film 3, as a focusing lens 4 made of a resin.

The dielectric multilayer filter 1b shown in Fig. 1(b) has the structure of a hybrid lens having: a light-transmissive substrate 2 in the form of a plate with two opposed flat surfaces; a dielectric multilayer film 3 formed on one side of the light-transmissive substrate 2; and a plane-convex lens made of a resin, as a focusing lens 4 made of a resin, with its flat surface glued on the surface of the substrate 2 opposite to the surface on which the dielectric multilayer film 3 is formed.

While the dielectric multilayer filters 1, 1b each have the dielectric multilayer film 3 provided only on one side of the plate-shaped light-transmissive substrate 2 and the resin focusing lens 4 only on one side of the light-transmissive substrate 2, the dielectric multilayer film 3 and resin focusing lens 4 may be provided on the two opposed sides of the light-transmissive substrate 2.

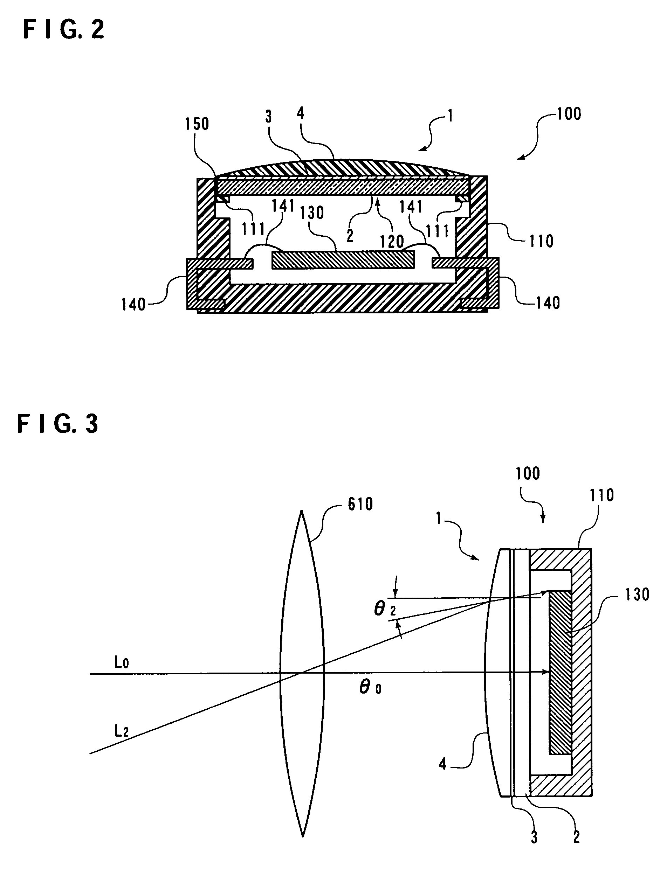

Fig. 2 shows, in cross section, a structure of an example of a solid-state imaging device in which the dielectric multilayer filter 1 shown in Fig. 1(a) is used as a dust-tight cover.

The solid-state imaging device 100 is a solid-state image sensor which is used in a digital still camera, digital video camera, etc. and which serves to convert an optical image into electric signals. The solid-state imaging device 100 has a package 110 shaped into a well, which is formed from an insulative material of a ceramic, a resin, etc. The package 110 includes an opening 120 (not shown) through which the light condensed by an optical system enters the inside of the package. Inside the package, a solid-state imaging element 130 such as a CCD or CMOS is fixed on the central portion of the bottom surface of the package with an adhesive, facing the opening 120. The solid-state imaging element 130 has a plurality of picture elements arrayed in two dimensions. There is provided an external connection line 140 for connecting between the inside and outside of the package 110, piercing a side wall of the package 110. The solid-state imaging element 130 and the external connection line are electrically connected with each other through a bonding wire 141. On the inner peripheral wall of the opening 120 of the package 110 is provided a stepped portion 111. The dielectric multilayer filter 1 of the invention is attached on the stepped portion 111 with its resin focusing lens 4 disposed outside, i.e., on the incident side thereof. With a sealing agent 150 interposed between the dielectric multilayer filter 1 and stepped portion 111, the dielectric multilayer filter 1 obturates the opening 120 as a dust-tight cover to seal the package 110, thereby to prevent dust from going into the package.

Fig. 3 shows an optical path illustration of assistance in explaining that the dielectric multilayer filter of the invention can make an incident angle with respect to the dielectric multilayer film smaller. The light coming from outside having passed through the optical system 610, which is schematically represented by a convex lens, travels toward the solid-state imaging element 130 of the solid-state imaging device 100 represented graphically and schematically. The light $L_0$ going along the optical axis of the optical system 610 passes through the resin focusing lens 4 and enters the dielectric multilayer film 3 perpendicularly to impinge on the center of the solid-state imaging element 130. In this case, the incident angle with respect of the dielectric multilayer film 3 is 0°. In contrast, the light $L_2$ which is to impinge on an end portion of the solid-state imaging element 130 is refracted so as to be converged toward the optical axis by the resin focusing lens 4 located on the incident side of the dielectric multilayer film 3, and enters the dielectric multilayer film 3 at an incident angle of $\theta_2$ smaller than the incident angle $\theta_1$ shown in Fig. 6 in the case without the resin focusing lens 4. Then, the light having passed the dielectric multilayer film 3 impinges on the solid-state imaging element 130. The resin focusing lens 4 serves as a lens for reducing an incident angle in this way. On that account, the resin focusing lens 4 must be a lens having a positive refractivity like a convex lens and must be disposed on the incident side of the dielectric multilayer film 3. The resin focusing lens 4 enables not only the reduction in the incident angle with respect to the dielectric multilayer film 3 but also the reduction in the incident angle with respect to the solid-state imaging element 130. In the above description, the dielectric multilayer filter 1 having the structure in which the dielectric multilayer film 3 is interposed between the resin focusing lens 4 and the light-transmissive substrate 2 has been explained. However, this applies absolutely also to the case of the dielectric multilayer filter 1b having, as a resin focusing lens 4, a resin plane-convex lens with a flat surface glued on a surface opposite to the surface on which the dielectric multilayer film 3 is formed.

The dielectric multilayer filters 1, 1b of the invention can reduce an incident angle with respect to the dielectric multilayer film 3, which tends to be larger nearer to an end portion of the solid-state imaging element 130. Therefore, the dielectric multilayer filters 1, 1b of the invention can reduce the angular dependence of the dielectric multilayer film 3, reduce the difference in color tone between the center and a near-edge portion of an image resulting from the conversion by the solid-state imaging element 130, and uniformize the image in color tone. While trying reducing the incident angle by the optical system may pose unreasonableness in design of the optical system, the method herein disclosed can reduce the degree of reliance on the optical system thereby to increase the degree of freedom in designing the optical system. Further, the resin focusing lens 4 can be formed by cast polymerization and as such, the convex optical surface thereof can be made aspheric easily. By making the optical surface aspheric, it becomes possible to arrange a focusing lens with its various kinds of aberrations corrected properly, and therefore an image of good quality can be obtained. Moreover, since the dielectric multilayer filter 1 of the invention can be manufactured by a method as described later at low cost, it is advantageous costwise.

The light-transmissive substrate 2, which each of the dielectric multilayer filters 1, 1b includes, is preferably heat-resistant so as to withstand a film formation process of the dielectric multilayer film 3 composed of tens of layers for reflecting light of a given wavelength because the substrate can be heated up to a temperature of about 200°C in order to form a thin film of good quality in the film formation process. In addition, it is difficult to uniformly grow the dielectric multilayer film 3 composed of tens of layers for reflecting light of the given wavelength on a curved surface. Therefore, the surface of the light-transmissive substrate 2 on which the dielectric multilayer film is formed must be flat, whereas other surface thereof may be curved surface like a lens. In general, it is preferable that the light-transmissive substrate 2 has at least an outermost surface layer made of a heat-resistant inorganic material and takes the form of a plate having two opposed flat surfaces.

Examples embodying the light-transmissive substrate 2 include: a white board; transparent amorphous inorganic glass plates of borosilicate glass, optical glass, etc.; absorption-type filter plates formed from the inorganic glass plates which have undergone a process of kneading the above inorganic glass plates with a substance capable of absorbing light of a particular wavelength; an optical low-pass filter composed of a single birefringent plate of quartz crystal, lithium niobate, or the like; an optical low-pass filter with a plurality of birefringent plates used therein; and an optical low-pass filter having the structure in which a polymer film is sandwiched as a quarter wave plate between two birefringent plates. The optical low-pass filter is disposed on the incident side of the solid-state imaging element and serves to carry out two- or four-point separation on the light incident on the solid-state imaging element to remove a higher spacial frequency component and thereby remove a pseudo signal. The optical low-pass filter has the function of suppressing the following phenomena: a horizontal line appears as a jagged line; and a monochrome checked pattern is colored.

The dielectric multilayer filter 1c shown in Fig. 1(c) is an example in which an optical low-pass filter having a first birefringent plate 21, a second birefringent plate 22, and a polymer film 23 used as a quarter wave plate and sandwiched between the first and second birefringent plates 21 and 22 is used as the light-transmissive substrate 2.

The first and second birefringent plates 21 and 22 are crystal plates of quartz crystal, lithium niobate, or the like having birefringent properties. For these plates, quartz crystal may be used for both the plates exclusively, or a combination of quartz crystal and lithium niobate may be used. Otherwise, other birefringent plates of different kinds of materials may be used in combination. The birefringence is a phenomenon in which incident light is separated into two rays having oscillating directions perpendicular to each other. The polymer film 23 is composed of a plastic film formed by a uniaxial stretching method. Adopting the thickness of the film appropriately in consideration of its birefringent property allows the polymer film 23 to serve as a quarter wave plate. The quarter wave plate is a sheet having a thickness which changes the light having passed therethrough so that the phase difference between an ordinary-light component and an extraordinary-light component thereof is a quarter cycle, and has the function of converting plane-polarized light into circularly polarized light. The optical low-pass filter is of a four-point separation and high performance type, and is thinner in comparison with a conventional optical low-pass filter including three birefringent plates. Therefore, the filter can be made thinner. Incidentally, in the case where so high performance is not required, only one birefringent plate may be used to constitute a two-point separation type optical low-pass filter.

When the light-transmissive substrate 2 is constituted by an optical low-pass filter, the function of the optical low-pass filter can be imparted to the dielectric multilayer filter 1. As a result, the number of parts can be reduced, thereby ensuring the downsizing of the imaging device.

An absorption-type filter plate may be used as the light-transmissive substrate 2 to make a dielectric multilayer filter in which an absorption-type filter for absorbing light of a particular wavelength and a dielectric multilayer film 3 for reflecting light of particular wavelength are combined. In this case, stray light, which is produced when the reflected light produced by reflection by the dielectric multilayer film 3 is reflected by another member and which enters the filter again, is absorbed by the absorption-type filter, whereby the stray light can be completely prevented from being incident on the solid-state imaging element.

The dielectric multilayer film 3 included in the dielectric multilayer filter 1 of the invention has the structure in which high-refractive-index layers and low-refractive-index layers are stacked on the light-transmissive substrate 2 alternately.

As the material of the high-refractive-index layer included in the dielectric multilayer film 3, $TiO_2$ (n=2.4), $Ta_2O_5$ (n=2.1), $Nb_2O_5$ (n=2.2), $ZrO_2$ (n=2.05), $Ta_2O_5$ (n=2.1), etc may be used. As the material of the low-refractive-index layer, $SiO_2$ (n=1.46), $Al_2O_3$ (n=1.63), $MgF_2$ (n=1.38), etc. may be used. The refractive indexes depend on wavelengths. The above refractive indexes n are values when the wavelength is 500nm.

In general, the basic design of the film thicknesses is represented in the form of a repeatedly-stacked layer, which has high-refractive-index layers and low-refractive-index layers alternately and repeatedly stacked respectively with an identical optical film thickness, as follows: $(05H, 1L, 0.5H)^s$, where a wavelength in a vicinity of the center of wavelengths that is desired to be cut off is indicated by $\lambda$; an optical film thickness $nd = 1/4\lambda$ is treated as a unit; the film thickness of the high-refractive-index layer (H) is denoted by 1H, and the film thickness of the low-refractive-index layer (L) is denoted by 1L likewise; s is the number of the repetition and referred to as a stack number, which represents that the configuration between paired round brackets is repeated periodically. The number of stacked layers which will be stacked actually is 2S+1. An increase in the value of S can make sharper the leading-edge property (steepness) in connection with the change from reflection to transmission. The value of S is adopted out of a range from 3 to 20 approximately. The repeatedly-stacked layer determines the particular wavelength to be cut off.

In order to increase the transmittance in the transmission band and to smooth the nonuniformity in light transmittance, which is referred to as a ripple, an optimal design is achieved by modifying some layers of the repeatedly-stacked layer near to the substrate and near to the physical medium in film thickness. Therefore, the designed is represented as follows: Substrate/ 0.5LH ... HL(HL)$^s$ HL ... H, 0.5L. Further, in the case where $TiO_2$, etc. is used for the high-refractive-index layers, it is often the case that the repeatedly-stacked layer is designed so as not to be terminated by a high-refractive-index layer as the outermost layer thereof, but to be terminated by adding $SiO_2$ superior in environmental resistance to the outermost layer. Also in regard to the layer adjacent to the substrate, $TiO_2$ could react with the substrate to deteriorate the characteristics thereof and as such, chemically stable $SiO_2$ can be added to the first layer. A multilayer-film cutoff filter like this can be designed using a commercially-available software logically (Reference Cited: OPTRONICS, p.175-190, No. 5, 1999).

A general means of growing high-refractive-index layers and low-refractive-index layers alternately on the light-transmissive substrate is a physical method of growing a film. Such method may be normal vacuum evaporation. However, ion-assist evaporation, ion-plating, and sputtering are more desirable as such method, because these methods enable stable control of the refractive index of a resultant film and makes it possible to produce a film with less aged deterioration in spectral characteristics owing to changes of storage and use environments. The vacuum evaporation is a technique of forming a thin film, including heating and evaporating a raw material for the thin film under a high vacuum condition to deposit particles resulting from the evaporation on a substrate. The ion-plating is a technique of ionizing particles for the deposition and accelerating the particles by an electric field thereby to cause the particles to adhere to a substrate. As such technique, there are APS (Advanced Plasma Source) and EBEP (Electron Beam Excited Plasma) methods, RF (Radio Frequency) direct substrate application method (i.e., a method of performing reactive vacuum evaporation in the condition where RF gaseous plasma is generated inside a film growth chamber), etc. The sputtering is a technique of forming a thin film, including: evaporating a material for the thin film through sputtering by which ions accelerated by an electric field is forced to collide with the thin film material thereby to knock out the material; and depositing the particles so evaporated on a substrate. The optical constants of the grown layer including a refractive index differ depending on the film-growth method, the film growth conditions, etc. Therefore, it is necessary to precisely measure the optical constants of a layer grown prior to the manufacturing.

In order to use the dielectric multilayer film 3 as e.g., an infrared cutoff filter, it is preferable that the half value, which is a wavelength indicating half of the maximum transmittance, falls in a range of $650 \pm 30$nm. Arranging the half value like this makes it possible to effectively block near infrared rays so as not to impinging on the solid-state imaging element.

The dielectric multilayer film having the spectral transmittance shown in Fig. 7 has been specifically grown as follows. As the material of the light-transmissive substrate, BK7 (which is a white board glass having a refractive index nd= 1.52) was used. In regard to the materials of used films, $Ta_2O_5$ was used for high-refractive-index layers (H) and $SiO_2$ was used for low-refractive-index layers (L). The means for film growth was an RF ion-plating system (manufactured by SHOWA SHINKU CO., LTD.).

The film thicknesses were arranged by 40 layers in total in order of increasing distance away from the substrate as follows: 1.141H, 1.088L, 1.03H, 1.01L, (0.994H, 0.994L)$^6$, 1.024H, 1.077L, 1.309H, 0.175L, 1.368H, 1.241L, 1.273H, 1.277L, (1.275H, 1.276L)$^6$, 1.257H, 1.278L, 1.254H, 0.626L, where λ= 755nm.

In addition, when the focusing lens 4 is provided on a surface of the light-transmissive substrate 2 on which the dielectric multilayer film 3 is not provided, it is desirable to further form an anti-reflection film on an outer surface of the resin focusing lens 4. The anti-reflection film may be a single-layer inorganic coating, a single-layer organic coating, or a multilayer structure composed of a plurality of layers of inorganic coating and organic coating. The materials usable as the material for the inorganic coating include the inorganic substances of $SiO_2$, $SiO$, $ZrO_2$, $TiO_2$, $TiO$, $Ti_2O_3$, $Ti_2O_5$, $Al_2O_3$, $Ta_2O_5$, $CeO_2$, $MgO$, $Y_2O_3$, $SnO_2$, $MgF_2$, and $WO_3$; these substances may be used independently or in combination of two or more of them. Further, in the case the anti-reflection film is arranged to have a multilayer structure, it is preferable that its outermost layer is $SiO_2$.

As the multilayer film of the inorganic coating may be exemplarily shown a structure composed of four layers of: from the side of the light-transmissive substrate, a $ZrO_2$ layer and a $SiO_2$ layer (total optical film thickness of whch is λ/4); a $ZrO_2$ layer (with an optical film thickness of λ/4); and a $SiO_2$ layer as the uppermost layer (with an optical film thickness of λ/4), where λ is a designed wavelength, and normally 520 nm.

The methods adoptable as the method of growing such inorganic coating film include, for example, vacuum evaporation, ion-plating, sputtering, CVD, and a method of precipitating the coating film through a chemical reaction in a saturated solution.

The materials usable for the organic coating film include, for example, FFP (tetrafluoroethylene-hexafluoropropylene copolymer), PTFE (polytetrafluoroethylene), and ETFE (ethylene-tetrafluoroethylene copolymer). In regard to the film growth method, such film may be grown by a coating method superior in mass production, such as spin-coating, and dip-coating, in addition to vacuum evaporation.

The shape of the resin focusing lens 4 formed on the dielectric multilayer film 3 on the light-transmissive substrate 2 or directly on the substrate 2 is designed so that the incident angle with respect to the dielectric multilayer film 3 is decreased. The resin focusing lens 4 can be formed on the light-transmissive substrate 2 by a usual manufacturing method of a hybrid lens. For example, a hybrid lens molding means may be constituted by a light-transmissive substrate 2 used as one molding die, and a convex face-forming-use molding die used as the other molding die having a concave cavity portion for transferring a convex face for the resin focusing lens 4. In this case, the hybrid lens molding means is prepared by a combination of a flat shaping face of the convex face-forming-use molding die having the concave cavity portion and a flat face of the light-transmissive substrate 2 to form the resin focusing lens 4 on it. The hybrid lens having its resin focusing lens 4 bonded on the light-transmissive substrate 2 can be manufactured by charging a material having a heat-curing or ultraviolet-curing resin composition into the concave cavity portion of the hybrid lens molding means, hardening the curing resin-based material by heat or ultraviolet radiation, and removing the convex face-forming-use molding die from the light-transmissive substrate. In brief, the shape of the optical surface of the resin focusing lens 4 can be formed by transferring the shape of the face of the concave cavity portion. The resin focusing lens 4 may be formed on one side or two opposed sides of the light-transmissive substrate 2. In the case where the resin focusing lenses 4 are formed on the two opposed surfaces, one resin focusing lens will refract the light output from the dielectric multilayer film 3 and as such, the one resin focusing lens may have, for example, the function of reducing the incident angle with respect to the solid-state imaging element 130.

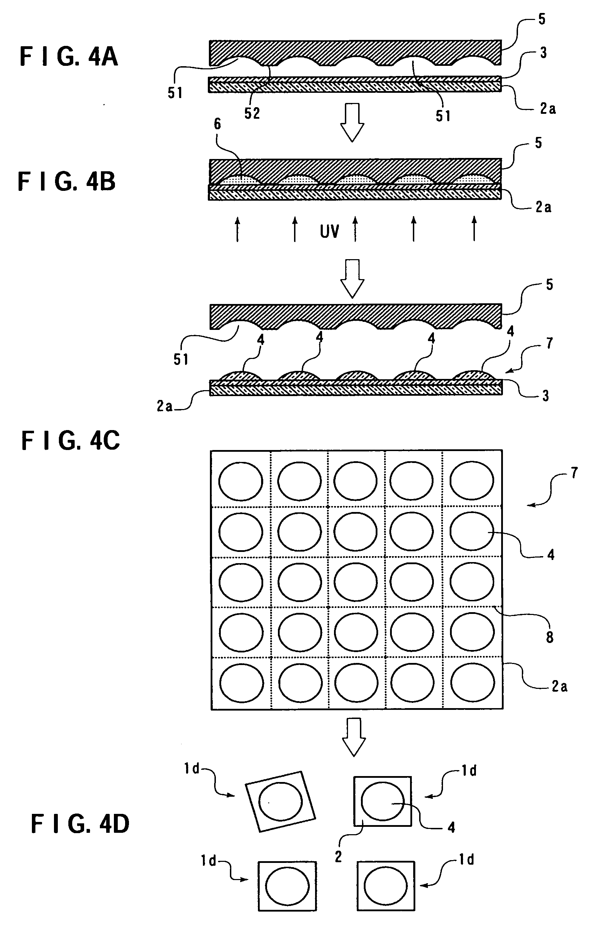

Next, the dielectric multilayer filter's manufacturing method which allows us to manufacture the dielectric multilayer filter of the invention at low cost will be described in reference to Fig. 4. The dielectric multilayer filter's manufacturing method has mainly a molding process and a dicing process.

First, as described in Fig. 4(a), a light-transmissive substrate 2a having a large area and a convex face-forming-use molding die 5 constituting a hybrid lens molding means are prepared. On one side or two opposed sides of the light-transmissive substrate 2a, a dielectric multilayer film 3 for reflecting light of a particular wavelength is previously formed. Now, it should be noted that it is difficult to form the dielectric multilayer film 3 after the resin focusing lens 4 has been stuck to the substrate because of the poor heat-resistance of the resin of which the resin focusing lens 4 is made. In addition, an anti-reflection film may be formed on one side of the light-transmissive substrate 2a. It is desirable to previously process the surface of the light-transmissive substrate 2a, on which the resin focusing lens 4 is to be formed, with a silane coupling agent, thereby to achieve better adhesion between the light-transmissive substrate 2a and resin focusing lens 4.

The convex face-forming-use molding die 5 has a flat shaping face 52 in which many concave cavity portions 51 for transferring the convex faces of the resin focusing lenses 4 are arrayed in a matrix form as shown in Fig. 4(c). Each concave cavity portion 51 is polished into a mirror-like geometrical condition which allows a given convex optical surface for the resin focusing lens 4 to be transferred. The convex face-forming-use molding die 5 can be made of a metal or an inorganic glass. The concave cavity portions 51 of the convex face-forming-use molding die 5 may be individually changed in the geometry of their concave faces and diameters thereby to enable the formation of plural types of resin focusing lenses 4. The convex face-forming-use molding die 5 and the light-transmissive substrate 2a have a common form and a common size so as to be superposed on each other when they are combined together.

Next, while the flat shaping face 52 of the convex face-forming-use molding die 5 is to be superposed on the flat surface of the light-transmissive substrate 2a on which the resin focusing lenses 4 are to be formed as shown in Fig. 4(b), the following two procedures are alternatively possible. The first is that a photo-hardening resin-based material 6 may be previously charged into the concave cavity portions 51 of the convex face-forming-use molding die 5, followed by superposing the convex face-forming-use molding die 5 on the light-transmissive substrate 2a. The second is that after having superposed the convex face-forming-use molding die 5 on the light-transmissive substrate 2a, the photo-hardening resin-based material 6 is charged into the concave cavity portions 51. Then, ultraviolet (UV) light is radiated from the side of the light-transmissive substrate 2a or the side of the convex face-forming-use molding die 5 when the convex face-forming-use molding die 5 is made of a glass, or from both the sides to cure the photo-hardening resin-based material 6 in the concave cavity portions 51.

Then, the light-transmissive substrate 2a is separated from the convex face-forming-use molding die 5, whereby a multi-cavity molded plate 7 as shown in Fig. 4(c) can be obtained. In the multi-cavity molded plate 7, many insular resin focusing lenses 4 arrayed in a matrix form are formed on one side of the light-transmissive substrate 2a as a result of the curing of the photo-hardening resin-based material; the resin focusing lenses 4 are individually bonded with the light-transmissive substrate 2a.

After that, an anti-reflection film may be formed on one surface of the multi-cavity molding 7 on which the resin focusing lenses 4 are formed or on the other surface thereof opposite to the one surface. Forming the anti-reflection film on the multi-cavity molding 7 enables simultaneous film formation with respect to many dielectric multilayer filters, and therefore the cost for film formation can be reduced.

Subsequently, in the dicing process, the light-transmissive substrate 2a is cut along the cutting lines 8 as indicated by dotted lines in Fig. 4(c) by dicing for each resin focusing lens 4, whereby many dielectric multilayer filters 1d can be cut off and manufactured. The dielectric multilayer filter 1d manufactured in this way has the structure in which a round resin focusing lens 4 bonded on one side of the rectangular light-transmissive substrate 2.

According to the dielectric multilayer filter's manufacturing method like this, growing the dielectric multilayer film 3 on the light-transmissive substrate 2a with a large area in one film formation process enables simultaneous film formation with respect to many dielectric multilayer filters in the one film formation process. Therefore, it becomes possible to reduce the cost for film formation of the dielectric multilayer film. In addition, in the molding process, many resin focusing lenses 4 can be formed on a surface of the light-transmissive substrate 2a in one molding operation. Also, in regard to the formation of the anti-reflection film, growing the film on the light-transmissive substrate 2a with a large area in one film formation process enables the film formation with respect to many dielectric multilayer filters in one film formation process. Consequently, the cost for film formation of the anti-reflection film can be reduced. In addition, many dielectric multilayer filters 1 can be simply and easily manufactured by cutting out the resin focusing lenses 4 for each lens in the dicing process. Therefore, the dielectric multilayer filters 1 can be manufactures at low cost.

[Example]

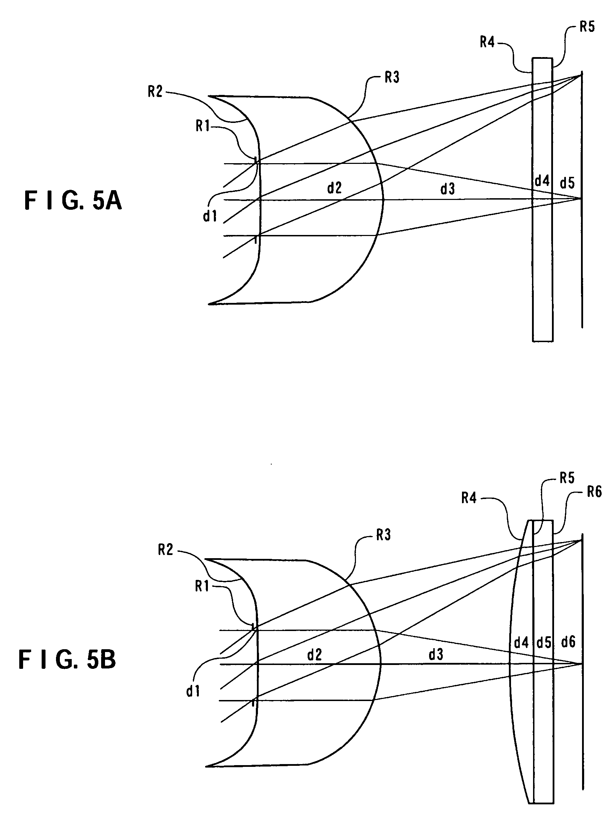

Table 1 shows design data of a dielectric multilayer filter having substantially the same view angle, as an example for comparison, with respect to light beams incident on points in a surface of a solid-state imaging element with a size of 1/3.6 in. (5mm diagonally), which are located 2.5 mm away from the center of solid-state imaging element. Table 2 shows design data in association with an example of the invention. Fig, 5(a) presents a cross sectional view of a lens of the example for comparison. Fig. 5(b) presents a cross sectional view of the lens of the example of the invention. In the cross sectional views of the lenses, the symbol Ri (i is an integer starting from one) indicates a lens face number in order from the incident side toward a solid-state imaging element, the symbol di (i is an integer starting from one) indicates a center thickness of the lens along the main light beam axis or an air gap between lenses in millimeters in order from the incident side toward the solid-state imaging element. In Tables 1 and 2, there are shown a curvature radius R at each lens face Ri in the lens cross sectional view shown in Fig. 5; a center thickness of each lens and an air gap between lenses, both denoted by di (mm); and a refractive index Nd and an Abbe number Vd with respect to a d line of the i-th numbered optical material in order from the incident side toward the solid-state imaging element. Also, in the lower lines of Tables 1 and 2, there are shown aspheric coefficients k, $A_4$, $A_6$, $A_8$, and $A_{10}$ in association with the following aspheric equation.

[Expression 1]

$$z = \frac{cr^2}{1 + \sqrt{1 - (1+k)c^2r^2}} \sqrt{+ A_4r^4 + A_6r^6 + A_8r^8 + A_{10}r^{10}}$$

where z is a value in a coordinate of a curved surface; r is a distance from the optical axis in a direction orthogonal to the optical axis; c is a curvature at the vertex of a lens; and k, $A_4$, $A_6$, $A_8$, and $A_{10}$ are aspheric coefficients respectively.

[Table 1]

| Face No. | Curvature Radius R (mm) | Distance d (mm) | Refractive Index Nd | Abbe Number Vd | |
|---|---|---|---|---|---|
| 1 | ∞ | 0.10 | | | Aperture |
| 2 | 57.38422 | 2.50 | 1.51633 | 64.1 | L1 |
| 3 | -2.12071 | 3.08 | | | |
| 4 | ∞ | 0.40 | 1.51633 | 64.1 | Dust-tight Cover |
| 5 | ∞ | 0.60 | | | |

| Aspheric Data | | | | | |
|---|---|---|---|---|---|
| Face No. | K | $A_4$ | $A_6$ | $A_8$ | $A_{10}$ |
| 2 | 0 | -2.3485-E-02 | -6.5960E-04 | -4.3070E-04 | -2.6047E-04 |
| 3 | 0 | 8.5238E-03 | -9.2359E-04 | 3.7057E-04 | 1.7337E-05 |

[Table 2]

| Face No. | Curvature Radius R (mm) | Distance d (mm) | Refractive Index Nd | Abbe Number Vd | |
|---|---|---|---|---|---|
| 1 | ∞ | 0.10 | | | Aperture |
| 2 | 57.38422 | 2.50 | 1.51633 | 64.1 | L1 |
| 3 | -2.12071 | 2.78 | | | |
| 4 | 20.000 | 0.40 | 1.49380 | 57.5 | |
| 5 | ∞ | 0.40 | 1.51633 | 64.1 | Dust-tight Cover |
| 6 | ∞ | 0.60 | | | |

| Aspheric Data | | | | | |
|---|---|---|---|---|---|
| Face No. | K | $A_4$ | $A_6$ | $A_8$ | $A_{10}$ |
| 2 | 0 | -2.3485-E-02 | -6.5960E-04 | -4.3070E-04 | -2.6047E-04 |
| 3 | 0 | 8.5238E-03 | -9.2359E-04 | 3.7057E-04 | 1.7337E-05 |

In the design of the example for comparison, the incident angle of a light beam incident on the point 2.5 mm away from the center of the solid-state imaging element at a dust-tight cover surface was 19.9°. However, the incident angle in the design of the example of the invention was 16.9°, and therefore the incident angle could be reduced by 3°. As a result, unevenness in color in an image could be improved. [Industrial Applicability]

The dielectric multilayer filter of the invention can be utilized for the application in which infrared rays are cut off so as not to enter a solid-state imaging element in a digital camera, etc.

The dielectric multilayer filter's manufacturing method of the invention can be utilized for the application in which the dielectric multilayer filter is manufactured at low cost.

The solid-state imaging element's device of the invention can be utilized for the application in which an optical image is converted into electric signals in an optical apparatus such as a digital camera.

[Description of the Reference Numerals]

1, 1b, 1c, 1d: DIELECTRIC MULTILAYER FILTER
2, 2a: LIGHT-TRANSMISSIVE SUBSTRATE
3: DIELECTRIC MULTILAYER FILM
4: RESIN FOCUSING LENS
21: FIRST BIREFRINGENT PLATE
22: SECOND BIREFRINGENT PLATE
23: POLYMER FILM (QUARTER WAVE PLATE)
100: SOLID-STATE IMAGING DEVICE

110: PACKAGE
120: OPENING
130: SOLID-STATE IMAGING ELEMENT
140: EXTERNAL CONNECTION LINE

**Claims**

1.  A dielectric multilayer filter comprising:

    a light-transmissive substrate having a flat surface on at least one side thereof;
    a dielectric multilayer film for reflecting light of a particular wavelength formed on the flat surface of said light-transmissive substrate; and
    a focusing lens made of a resin glued on the at least one side of said light-transmissive substrate.

2.  The dielectric multilayer filter of Claim 1, wherein said light-transmissive substrate has at least one birefringent plate.

3.  The dielectric multilayer filter of Claim 1, wherein said light-transmissive substrate is an optical low-pass filter having a first birefringent plate,
    a second birefringent plate and
    a polymer film serving as a quarter wave plate and sandwiched between the first birefringent plate and the second birefringent plate.

4.  The dielectric multilayer filter of Claim 1, wherein said light-transmissive substrate is an absorption-type filter for absorbing light of a particular wavelength.

5.  The dielectric multilayer filter of any one of Claims 1-4, wherein an outer surface of said resin focusing lens is aspheric.

6.  The dielectric multilayer filter of any one of Claims 1-5, wherein a half value, which is a wavelength indicating half of a maximum transmittance of said dielectric multilayer film, falls in a range of $650 \pm 30$nm.

7.  A method of manufacturing a dielectric multilayer filter, comprising:

    a molding process including the steps of
    preparing a hybrid lens molding means by combining a light-transmissive substrate in a plate form having a dielectric multilayer film for reflecting light of a particular wavelength provided on one side or two opposed sides thereof, and a convex face-forming-use molding die having a shaping face and a plurality of concave cavity portions each for transferring a focusing lens form provided in the shaping face, with the shaping face facing said light-transmissive substrate,
    charging a curable composition-based material into the plurality of concave cavity portions of said hybrid lens molding means, and
    curing the curable composition-based material;
    a dicing process including the steps of
    removing the convex face-forming-use molding die, and
    dicing said light-transmissive substrate for each resin focusing lens formed on a surface of said light-transmissive substrate by curing the curable composition-based material.

8.  A solid-state imaging device comprising:

    a package having an opening;
    a solid-state imaging element secured inside said package so as to face the opening; and
    a light-transmissive dust-tight cover for obturating the opening,

    wherein said dust-tight cover is a dielectric multilayer filter having: a light-transmissive substrate in a plate form;
    a dielectric multilayer film for reflecting light of a particular wavelength, the dielectric multilayer film formed on at least one side of said light-transmissive substrate; and

a resin focusing lens glued to a face on an incident side of said light-transmissive substrate.

F I G. 1A

F I G. 1B

F I G. 1C

# FIG. 2

# FIG. 3

FIG. 4A

FIG. 4B

UV

FIG. 4C

FIG. 4D

F I G. 5A

F I G. 5B

16

# F I G. 6

# FIG. 7

# F I G. 8

**European Patent Office**

**EUROPEAN SEARCH REPORT**

Application Number

EP 05 00 3132

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 239 519 A (CANON KABUSHIKI KAISHA) 11 September 2002 (2002-09-11) * paragraphs [0127] - [0133], [0155] - [0166]; figure 26b * ----- | 1,5-8 | G02B5/28 G02B3/00 H01L31/0232 H01L31/0216 |
| X | US 2003/038938 A1 (JUNG WAYNE D ET AL) 27 February 2003 (2003-02-27) * paragraphs [0101], [0102], [0105], [0193], [0200], [2001]; figure 17 * ----- | 1,4,5,8 | |
| X | EP 1 152 281 A (SEIKO EPSON CORPORATION) 7 November 2001 (2001-11-07) * paragraphs [0115], [0116]; figure 13 * ----- | 1,2 | |
| A | EP 0 859 265 A (DAI NIPPON PRINTING CO., LTD) 19 August 1998 (1998-08-19) * page 7, line 32 - page 8, line 27; figures 7,8 * ----- | 1-3 | |
| A | US 5 177 605 A (TAKAHASHI ET AL) 5 January 1993 (1993-01-05) * column 8, line 47 - column 9, line 36; figure 15 * ----- | 1,8 | TECHNICAL FIELDS SEARCHED (Int.Cl.7) G02F H01L G02B |
| A | US 5 986 704 A (ASAI ET AL) 16 November 1999 (1999-11-16) * columns 4,5; claim 2 * ----- | 1,8 | |

The present search report has been drawn up for all claims

| Place of search | Date of completion of the search | Examiner |
|---|---|---|
| Berlin | 25 May 2005 | von Moers, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 05 00 3132

This annex lists the patent family members relating to the patent documents cited in the above-mentioned European search report.
The members are as contained in the European Patent Office EDP file on
The European Patent Office is in no way liable for these particulars which are merely given for the purpose of information.

25-05-2005

| Patent document cited in search report | | Publication date | Patent family member(s) | | Publication date |
|---|---|---|---|---|---|
| EP 1239519 | A | 11-09-2002 | CN | 1377181 A | 30-10-2002 |
| | | | EP | 1239519 A2 | 11-09-2002 |
| | | | JP | 2003204053 A | 18-07-2003 |
| | | | TW | 536833 B | 11-06-2003 |
| | | | US | 2004012698 A1 | 22-01-2004 |
| US 2003038938 | A1 | 27-02-2003 | NONE | | |
| EP 1152281 | A | 07-11-2001 | EP | 1152281 A1 | 07-11-2001 |
| | | | US | 6738115 B1 | 18-05-2004 |
| | | | CN | 1335943 A | 13-02-2002 |
| | | | WO | 0133290 A1 | 10-05-2001 |
| | | | TW | 573164 B | 21-01-2004 |
| | | | US | 2004183969 A1 | 23-09-2004 |
| EP 0859265 | A | 19-08-1998 | JP | 10232313 A | 02-09-1998 |
| | | | EP | 0859265 A2 | 19-08-1998 |
| | | | TW | 382071 B | 11-02-2000 |
| | | | US | 2002003593 A1 | 10-01-2002 |
| | | | US | 2003164906 A1 | 04-09-2003 |
| US 5177605 | A | 05-01-1993 | JP | 1125417 U | 28-08-1989 |
| | | | JP | 63269112 A | 07-11-1988 |
| | | | JP | 1033516 A | 03-02-1989 |
| | | | US | 4916534 A | 10-04-1990 |
| US 5986704 | A | 16-11-1999 | JP | 10189929 A | 21-07-1998 |

EPO FORM P0459

For more details about this annex : see Official Journal of the European Patent Office, No. 12/82